# EUROPEAN PATENT APPLICATION

(11) **EP 2 323 169 A1**
(43) Date of publication of application: **18.05.2011**
(21) Application number: 09809501.1
(22) Date of filing: 19.08.2009
(51) Int. Cl.: H01L 31/04

(54) **METHOD FOR MANUFACTURING SOLAR CELL**

(30) Priority: 29.08.2008 JP 2008222171
(71) Applicant: Ulvac, Inc., Chigasaki-shi Kanagawa 253-8543 (JP)
(72) Inventor: YAMAMURO, Kazuhiro, Chigasaki-shi Kanagawa 253-8543 (JP); YUYAMA, Junpei, Chigasaki-shi Kanagawa 253-8543 (JP); YAMANE, Katsumi, Chigasaki-shi Kanagawa 253-8543 (JP)
(74) Representative: Eisenführ, Speiser & Partner
(86) International application number: PCT/JP2009/003956
(87) International publication number: WO 2010/023845

(57) **Abstract**

The present invention provides a photovoltaic cell manufacturing method, the photovoltaic cell including: a photoelectric converter in which at least a first electrode layer, a semiconductor layer, and a second electrode layer are stacked in layers in this order being formed on a face of a substrate; and a connection portion of the first electrode layer and the second electrode layer, the photoelectric converter having a plurality of compartment elements which are electrically separated by a predetermined size using scribing lines at which the semiconductor layer and the second electrode layer are removed, adjacent compartment elements being electrically connected to each other, the photovoltaic cell manufacturing method comprising: a defect region specifying step in which a region at which the structural defect exists is specified in the photoelectric converter; and a repairing step in which at least three repair lines in which the semiconductor layer and the second electrode layer are removed are formed by irradiating the photoelectric converter with a laser, the region at which the structural defect exists is surrounded by at least three repair lines described above and one of the scribing lines, and the structural defect is removed or separated off, wherein one of at least three repair lines described above are formed at a region between the structural defect and the connection portion and at a region α including a contact portion of the semiconductor layer and the substrate in the photoelectric converter.

## Description

### BACKGROUND OF THE INVENTION

### Field of the Invention

The present invention relates to a photovoltaic cell manufacturing method.

Particularly, the present invention relates to a photovoltaic cell manufacturing method which forms repair line by removing a semiconductor layer and a second electrode layer with a laser, and can reliably remove and separate a structural defect region from a normal region using the repair line and a scribing line.

Additionally, in details, the present invention relates to a photovoltaic cell manufacturing method which can minimize degradation of the photoelectric conversion efficiency by minimizing the area that is used for removing and separating a structural defect region from a normal region.

This application claims priority from Japanese Patent Application No. 2008-222171 filed on August 29, 2008, the contents of which are incorporated herein by reference in their entirety.

### Background Art

In recent years, in view of efficient use of energy, photovoltaic cells have been more widely used than ever before.

Specifically, a photovoltaic cell in which a silicon single crystal is utilized has an excellent energy conversion efficiency per unit area.

However, in the photovoltaic cell in which the silicon single crystal is utilized, a silicon single crystal ingot is sliced, the sliced silicon wafer that is obtained is used in the photovoltaic cell; therefore, a large amount of energy is spent for manufacturing the silicon single crystal ingot.

Consequently, the manufacturing cost of the photovoltaic cell in which the silicon single crystal is utilized is high.

Specifically, at the moment, in a case of realizing a photovoltaic cell having a large area which is placed out doors or the like, when the photovoltaic cell is manufactured by use of a silicon single crystal, the cost considerably increases.

Consequently, as a low-cost photovoltaic cell, a photovoltaic cell that can be further inexpensively manufactured and that employs a thin film made of amorphous silicon is in widespread use.

An amorphous silicon photovoltaic cell has semiconductor films of a layered structure that is referred to as a pin-junction in which an amorphous silicon film (i-type) generating electrons and holes when receiving light is sandwiched between p-type and n-type silicon films.

An electrode is formed on both faces of the semiconductor films.

The electrons and holes generated when receiving sunlight actively transfer due to a difference in the electrical potentials between p-type and n-type semiconductors.

When the transfer is continuously repeated, a difference in the electrical potentials between the electrodes formed at both faces of the semiconductor film is generated.

In an example of specific constitution of the above-described amorphous silicon photovoltaic cell, a transparent electrode such as TCO is formed as a lower electrode on a glass substrate that becomes a light receiving face side, and an amorphous silicon (semiconductor film) and an Ag thin film or the like (upper electrode) are formed on the lower electrode.

In the amorphous silicon photovoltaic cell that is provided with a photoelectric converter having the upper electrode, the lower electrode, and the semiconductor film as described above, if each of the layers having a large area is only uniformly formed on the substrate, there is a problem in that the difference in the electrical potentials is small and there is a problem of resistance.

Because of this, in the photoelectric converter, a plurality of compartment elements are formed.

The compartment elements electrically partition the photoelectric converter by a predetermined size, and are configured so that adjacent compartment elements are electrically connected to each other.

Specifically, by using a laser light or the like, grooves which are referred to as scribing line are formed on the photoelectric converter that is uniformly formed on a substrate and has a large area, a plurality of compartment elements formed in a longitudinal rectangular shape is thereby formed.

In addition, adjacent compartment elements are electrically connected in series.

However, in the amorphous silicon photovoltaic cell having the foregoing structure, it is known that several structural defects occur during a manufacturing step therefor.

For example, in forming the amorphous silicon film, the upper electrode and the lower electrode may be locally short-circuited because particles mix thereto or pin holes occur therein.

In addition, when a part of the photoelectric converter that was formed on the substrate is divided into a plurality of compartment elements by the scribing line that is formed by, for example, laser light, a metal film that forms the upper electrode is molten along the scribing line, the molten metal film is in contact with the lower electrode, and the upper electrode and the lower electrode may be locally short-circuited.

As described above, in the photoelectric converter, when structural defects occur such that the upper electrode and the lower electrode are locally short-circuited with the semiconductor film interposed therebetween, the defects cause malfunction such that power generation voltage or photoelectric conversion efficiency are degraded.

Consequently, in the process for manufacturing a conventional amorphous silicon photovoltaic cell, malfunction is repaired using a step for detecting the structural defects such as the foregoing short-circuiting or the like or a step for removing the portions at which the structural defects exist.

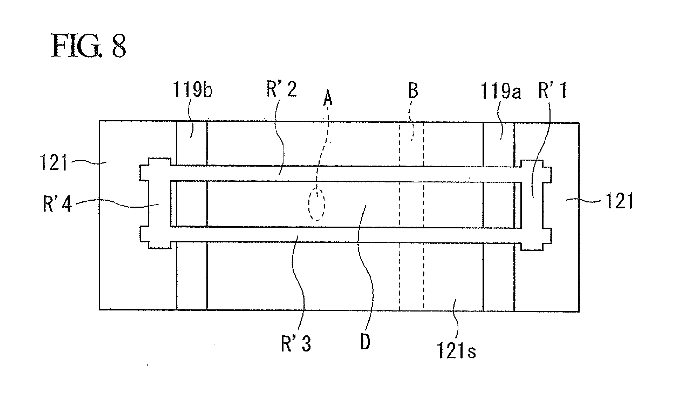

In order to insulate the portion at which the structural defect occurs, for example, as shown in FIG. 8 in conventional, repair lines (R'1 to R'4) which remove three layers of a transparent conductivity film (lower electrode), a back face electrode (upper electrode), and a semiconductor junction layer (semiconductor film) are formed by laser irradiation such that the laser crosses over scribing lines 119 (119a, 119b), and a structural defect A is removed or separated off.

However, in the case of removing the structural defect A while crossing over the scribing lines 119 (119a, 119b) that cause the transparent conductivity film (lower electrode) to be electrically connected to the back face electrode (upper electrode), it is necessary to remove the three layers of the transparent conductivity film (lower electrode), the semiconductor junction layer (semiconductor film), and the back face electrode (upper electrode) for secure insulation.

In order to remove of the three layers, a plurality of time of laser irradiation is necessary, and steps therefore increase.

Furthermore, there is a concern in that a photoelectric converter of a photovoltaic cell is damaged.

The invention was made in view of the above-described circumstances, and has an object to provide a photovoltaic cell manufacturing method, which suppress negative effects occurring at a normal region in which a defect does not exist in a photovoltaic cell, and which can reliably separate or remove a defect portion from a normal region.

### SUMMARY OF THE INVENTION

In order to solve the above-described problem, the present invention provides the following photovoltaic cell manufacturing method.
(1) The present invention provides a photovoltaic cell manufacturing method. The photovoltaic cell includes: a photoelectric converter in which at least a first electrode layer, a semiconductor layer, and a second electrode layer are stacked in layers in this order being formed on a face of a substrate; and a connection portion of the first electrode layer and the second electrode layer. The photoelectric converter has a plurality of compartment elements which are electrically separated by a predetermined size using scribing lines at which the semiconductor layer and the second electrode layer are removed. Adjacent compartment elements are electrically connected to each other. The photovoltaic cell manufacturing method includes: a defect region specifying step in which a region at which the structural defect exists is specified in the photoelectric converter; and a repairing step in which at least three repair lines in which the semiconductor layer and the second electrode layer are removed are formed by irradiating the photoelectric converter with a laser, the region at which the structural defect exists is surrounded by at least three repair lines described above and one of the scribing lines, and the structural defect is removed or separated off.

In the photoelectric converter, one of at least three repair lines described above are formed at a region between the structural defect and the connection portion and at a region α including a contact portion of the semiconductor layer and the substrate in the photoelectric converter.
(2) In the above-described photovoltaic cell manufacturing method (1), one repair line may be formed at a region β between the structural defect and the contact portion in the region α.
(3) In the above-described photovoltaic cell manufacturing method (1), one repair line is formed at a region γ between the contact portion and the connection portion in the region α.

### Effects of the Invention

According to the above-described invention (1), one repair line is formed between the structural defect and the connection portion of the first electrode layer and the second electrode layer and is formed at the region α including the portion at which the semiconductor layer is in contact with the substrate; and, by using the repair line, at least two of the other repair lines, and the scribing line, it is possible to reliably remove and separate the region at which the structural defect exists.

Additionally, a region which is removed or separated from a normal region becomes lower than ever before. Since it is only necessary to remove two layers of the semiconductor layer and the second electrode layer with a laser in the repair line, it is possible to reduce the number of removal processes with a laser, which is lower than ever before, and suppressing an adverse affect to a normal region of a photovoltaic cell.

Therefore, it is possible to manufacture a photovoltaic cell having a high level of photoelectric conversion efficiency without a structural defect.

According to the above-described inventions (2) and (3), it is possible to narrow down the region further which is to be removed or separated from the normal amount region more than that of the above-described invention (1), and it is possible to repair the defect portion without significant degradation of the characteristics of a photovoltaic cell and without resulting in disfigurement.

Because of this, it is possible to manufacture a photovoltaic cell having a high level of photoelectric conversion efficiency without a structural defect.

### BRIEF DESCRIPTION OF THE DRAWINGS

FIG. 1 is an enlarged perspective view showing a main section of an example of a photovoltaic cell of the present invention.
FIG. 2A is a partial cross-sectional view of the photovoltaic cell.
FIG. 2B is a partial enlarged view of Z portion of FIG. 2A.
FIG. 3 is a flowchart schematically representing a photovoltaic cell manufacturing method of an embodiment of the present invention.
FIG. 4 is a cross-sectional view showing a photovoltaic cell in which an example of structural defect exists.
FIG. 5 is an explanatory diagram showing a state of defect region specifying step.
FIG. 6A is a cross-sectional view at the time of forming three repair lines (R1 to R3).
FIG. 6B is a top view at the time of forming three repair lines (R1 to R3).
FIG. 6C is a top view at the time of forming four repair lines (R1 to R4).
FIG. 7A is a cross-sectional view at the time of forming three repair lines (R1 to R3).
FIG. 7B is a top view at the time of forming three repair lines (R1 to R3).
FIG. 7C is a top view at the time of forming four repair lines (R1 to R4).
FIG. 8 is a top view showing an example of conventional defect repairing step.

### DESCRIPTION OF THE PREFERRED EMBODIMENTS

Hereinafter, an embodiment of a photovoltaic cell manufacturing method related to the present invention will be described with reference to drawings.

The embodiment is specifically explained for appropriate understanding the scope of the present invention, and does not limit the present invention unless otherwise specified.

Also, for convenience, the drawings used in below explanation may indicate a portion that becomes relevant part of the present invention in a enlarged state for appropriate understanding the features of the present invention, and the size of each constituent element is not limited to the same size as a practical element.

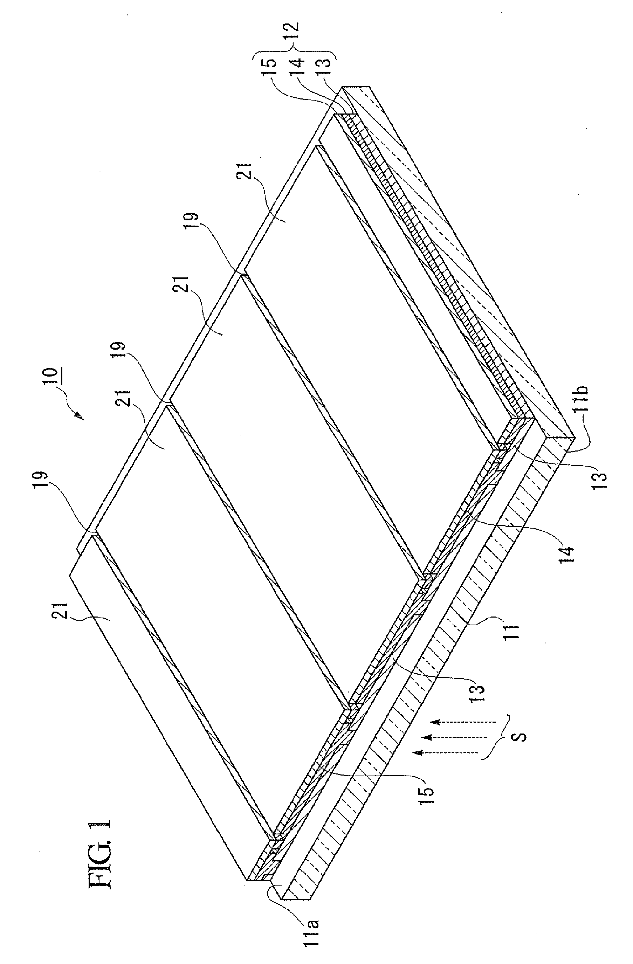

FIG. 1 is an enlarged perspective view showing an example of a main section of an amorphous silicon type photovoltaic cell which is manufactured by a photovoltaic cell manufacturing method of the present invention.

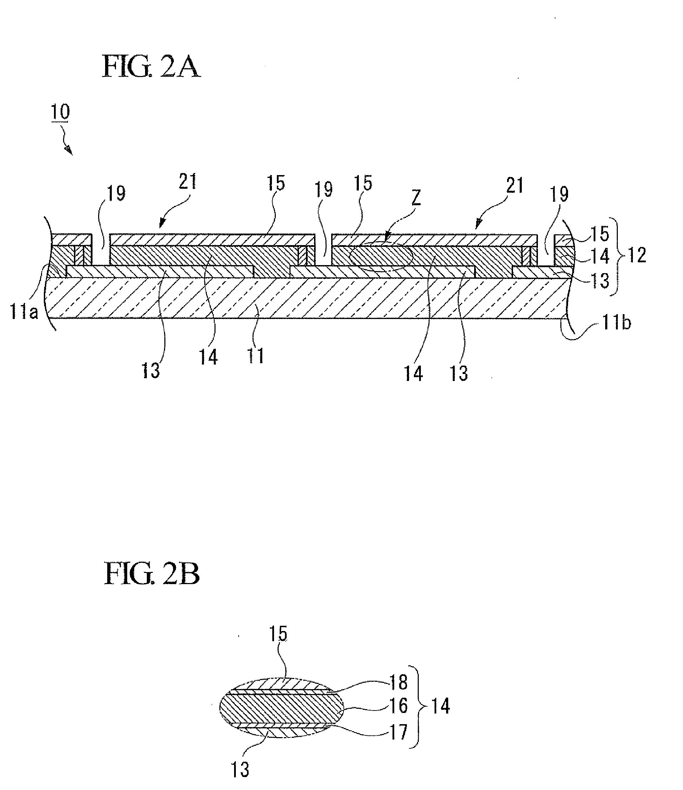

In addition, FIG. 2A is a cross-sectional view partially showing a layered structure of the photovoltaic cell shown in FIG. 1.

A photovoltaic cell 10 has a transparent substrate 11 having an insulation property and a photoelectric converter 12 formed on a face 11 a of the substrate 11.

The substrate 11 may be composed of an insulation material having a high level of sunlight transparency and durability such as a glass or a transparent resin.

Sunlight S is incident to the other face 11b of the substrate 11.

In the photoelectric converter 12, a first electrode layer 13 (lower electrode), a semiconductor layer 14, and a second electrode layer 15 (upper electrode) are stacked in layers in order from the substrate 11.

The first electrode layer 13 (lower electrode) may be formed of a transparent conductive material, for example, an oxide of metal having an optical transparency such as TCO or ITO.

In addition, the second electrode layer 15 (upper electrode) may be formed of a conductive metal film such as Ag or Cu.

As shown in FIG. 2B, the semiconductor layer 14 has, for example, a pin-junction structure in which an i-type amorphous silicon film 16 is sandwiched between a p-type amorphous silicon film 17 and an n-type amorphous silicon film 18.

Consequently, when sunlight is incident to the semiconductor layer 14, electrons and holes are generated, electrons and holes actively transfer due to a difference in the electrical potentials between the p-type amorphous silicon film 17 and the n-type amorphous silicon film 18; and when the transfer thereof is continuously repeated, a difference in the electrical potentials between the first electrode layer 13 and the second electrode layer 15 is generated.

This phenomenon is referred to as photoelectric conversion.

The photoelectric converter 12 is divided by a scribing line 19 (scribing line) into a plurality of compartment elements 21, 21 ··· whose external form is, for example, a longitudinal rectangular shape.

The compartment elements 21, 21 ··· are electrically separated from each other by the scribing line 19, and adjacent compartment elements 21 are electrically connected in series therebetween.

By means of this structure, since the photoelectric converter 12 is in a state where all of the compartment elements 21, 21 ··· are electrically connected in series, it is possible to extract an electrical current with a high degree of difference in the electrical potentials.

The scribing lines 19 may be formed, for example, by forming grooves with a predetermined distance therebetween on the photoelectric converter 12 using a laser beam or the like after the photoelectric converter 12 was uniformly formed on the face 11a of the substrate 11.

In addition, it is preferable that a protective layer (not shown) made of a resin of insulation or the like be further formed on the second electrode layer 15 (upper electrode) constituting the foregoing photoelectric converter 12.

A manufacturing method for manufacturing a photovoltaic cell having the foregoing structure will be described.

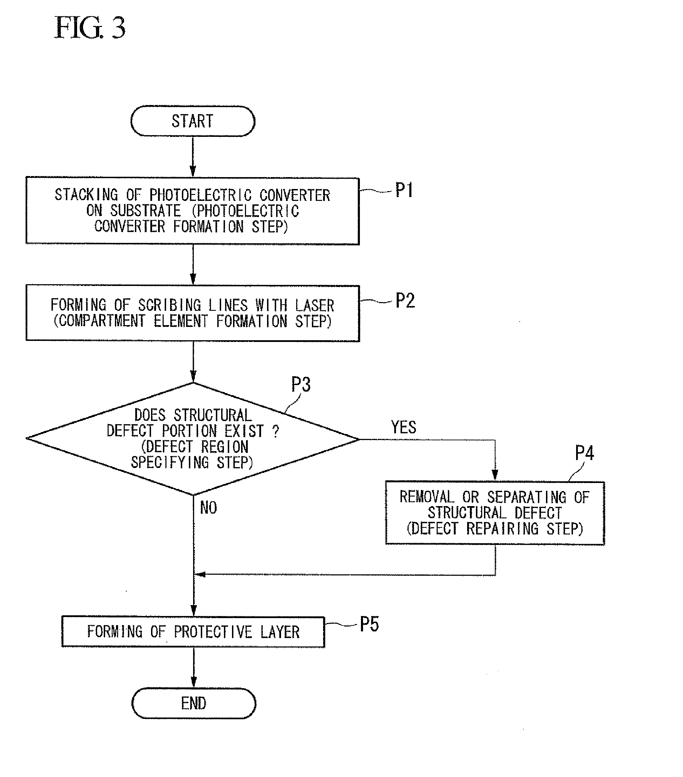

FIG. 3 is a flowchart illustrating a method for manufacturing the photovoltaic cell of the present invention in a stepwise manner.

In the method, specifically, steps between steps of detecting and repairing of a structural defect will be described in detail.

Firstly, as shown in FIG. 1, a photoelectric converter 12 is formed on a face 11a of a transparent substrate 11 (photoelectric converter formation step: P1).

In the photoelectric converter 12, for example, a first electrode layer 13 (lower electrode), a semiconductor layer 14, a second electrode layer 15 (upper electrode) may be formed by stacking in order from the substrate 11.

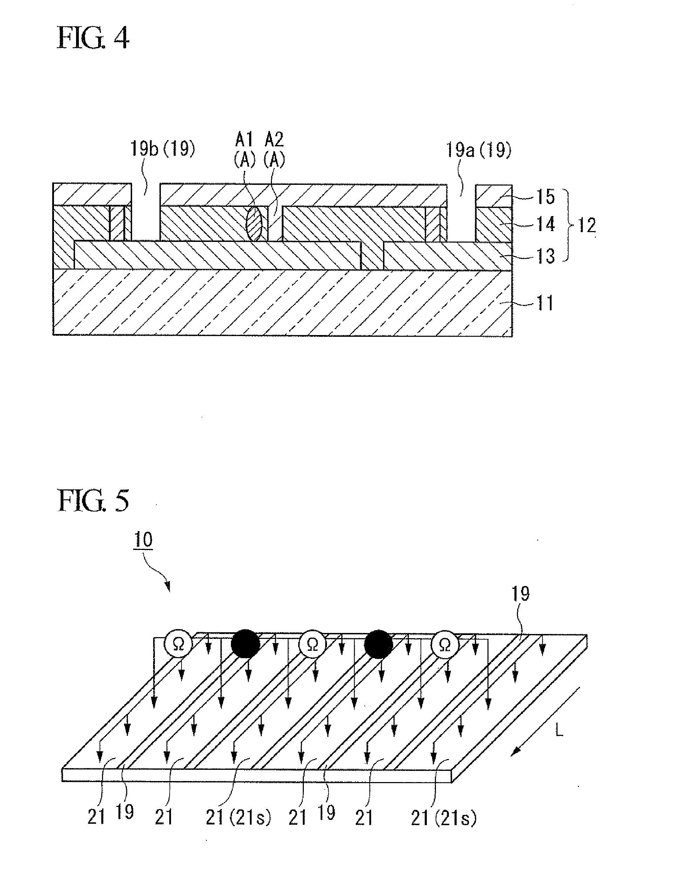

In the step of forming the foregoing photoelectric converter 12, as shown in FIG. 4, there is a case where malfunction is generated such as a structural defect A1 as a result of contamination which is caused by mixing impurities or the like into the semiconductor layer 14 or a structural defect A2 at which microscopic pin holes are generated in the semiconductor layer 14.

The foregoing structural defects A (A1, A2) cause the first electrode layer 13 and the second electrode layer 15 to be locally short-circuited (leakage) therebetween, and degrade the power generation efficiency.

Next, a scribing line 19 is formed on the photoelectric converter 12 by irradiating the photoelectric converter 12, for example, with a laser beam or the like.

Because of this, a plurality of compartment elements 21, 21 ··· which are formed in a longitudinal rectangular shape shown in FIG. 1 are formed on the photoelectric converter 12 (compartment element formation step: P2).

Subsequently, the photovoltaic cell 10 which is formed in the above described processes is subjected to a defect region specifying step (P3) and / or a defect repairing step (P4), thereafter, is subjected to a step (P5) of forming a protective layer or the like, and is completed.

In the defect region specifying step (P3), a region D of each compartment element 21 in which a structural defect A typified by the above-described A1 and A2 exists is specified.

In the defect repairing step (P4), the region D which is detected in the above-described defect region specifying step (P3) and in which the structural defect A exists is removed or separated from a normal region, and thereby repairing is performed.

As described below, an example of the foregoing defect region specifying step (P3) and defect repairing step (P4) is specifically described.

### Defect Region Specifying Step (P3)

The defect region specifying step (P3) is not limited to a specific step as long as the step can specify a portion in which a defect exists; and the defect region specifying step may specify a portion in which a defect exists based on, for example, a result of measurement of resistance, measurement of FF (fill factor), capturing images using a CCD camera or the like.

In the case where the compartment element 21s in which the structural defect A exists and the region D in which the structural defect A exists are specified by measuring the resistance, as shown in FIG. 5, firstly several measuring points are set along the longitudinal direction L of the compartment element 21 formed in a longitudinal rectangular shape.

Consequently, resistances are measured between adjacent compartment elements 21 and 21.

It is possible to specify the compartment element 21s in which the structural defect A exists and the region D in which the structural defect A exists based on the distribution of the measured values (decrease of resistance).

At this time, by use of a measuring apparatus in which probes are arrayed along the longitudinal direction L of the compartment element 21 by a predetermined distance, a method in which the measuring of the resistance between compartment elements 21, 21... is completed by one-time moving the probe vertically, or a measuring method in which the probe is scanned along the longitudinal direction L of the compartment elements 21 by repeatedly moving the probe vertically at a predetermined measuring point, or the like may be adopted.

In the case where structural defect A is specified in the above-described manner, as a resistance measuring method, any method may be adopted such as a method for applying a predetermined bias voltage and measuring of an electrical current value by using two probes that constitute a pair thereof, or a method for applying a predetermined bias electrical current and measuring a voltage value by using different probes which are four probes that constitute two pairs thereof.

A resistance is calculated based on the voltage value and the electrical current value.

As a different detection method, the measurement interval between the terminals may be changed based on threshold values which is predetermined in advance.

The threshold values, for example, X, Y, and Z (X>Y>Z) of resistance are determined in advance. If the resistance is greater than or equal to the threshold value X, the measurement is performed every ten terminals (measurement interval between the terminals is ten); if the resistance is less than or equal to threshold value X, the measurement is performed every five terminals (measurement interval between the terminals is five); if the resistance is less than or equal to threshold value Y, the measurement is performed every two terminals (measurement interval between the terminals is two); and if the resistance is less than or equal to threshold value Z, the measurement is performed every each terminal (measurement interval between the terminals is one).

If the resistance is high, conversely, by increasing the measurement interval each time the resistance exceed the threshold value, the measurement is performed.

If the structural defect A exist, since the resistances gradually vary, by changing the measurement interval every of threshold value as described above, it is possible to quickly and accurately detect the position of the structural defect A.

Similarly, in the defect region specifying step (P3) based on measurement of FF, by comparing FF values of adjacent compartment elements 21, 21, a region where FF value is specifically dropped can be specified as the region D in which the structural defect A exists.

In the defect region specifying step (P3) based on the capturing with a CCD camera, for example, the CCD camera and a lens having a high magnification ratio are combined.

In order to determine the position of the structural defect A based on the captured image, it may be determined by visual contact, additionally, it may be determined by comparing image data of the compartment element which is an object to be inspected and image data of the compartment element in which a defect does not exist and which is captured in advance by use of a computer.

In the defect region specifying step described above, in the case where a region in which a structural defect A exists is found in a photovoltaic cell ("YES" in P3), the defect repairing step (P4) subsequently described is performed.

On the other hand, in the case where the compartment element 21s in which a structural defect A exists is not found in a photovoltaic cell ("NO" in P3), the photovoltaic cell is determined as a non-defective product while being unmodified, and a step P5 for forming a protective layer or the like is performed, thereafter, the photovoltaic cell becomes a final product.

In addition, by performing the above-described defect region specifying step (P3) in a plurality times, it is possible to further particularly specify the region D in which the structural defect A exists.

In this case, it is preferable that the interval for measuring the resistance be finer than the interval for measuring the resistance in all of the steps.

Additionally, measuring a resistance or an FF, appropriately combining captured image by a CCD camera, or specifying the region D in which the structural defect A exists can be employed.

For example, after roughly narrowing down a region D in which a structural defect A exists by performing measurement of resistance distribution or FF, the narrowed region is further captured with an image capturing device such as a CCD camera, and it is thereby possible to specify an exact position of a structural defect A which exists in a compartment element.

In the case where a defect region is specified by capturing an object having a large-area to be inspected, a great amount of time is necessary; however, by narrowing a region to be captured down to a region having a small area in advance based on a resistance distribution or the like which is measurable in a short time in the above-described manner, it is possible to extremely and quickly specify an exact position of structural defect A in a short time.

### Defect Repairing Step

In the defect repairing step (P4), the structural defect A (A1, A2) of the photovoltaic cell in which the exact position is specified is repaired.

In the defect repairing step (P4), the region D is irradiated with a laser in which the structural defect A specified in the above-described defect region specifying step (P3) exists, and the semiconductor layer 14 and the second electrode layer 15 of the region D in which a structural defect A exists are removed.

In the defect repairing step (P4), since the exact position in which the structural defect A is specified in the compartment element 21 in the defect region specifying step (P3), it is possible to remove only the small-limited region including the structural defect A.

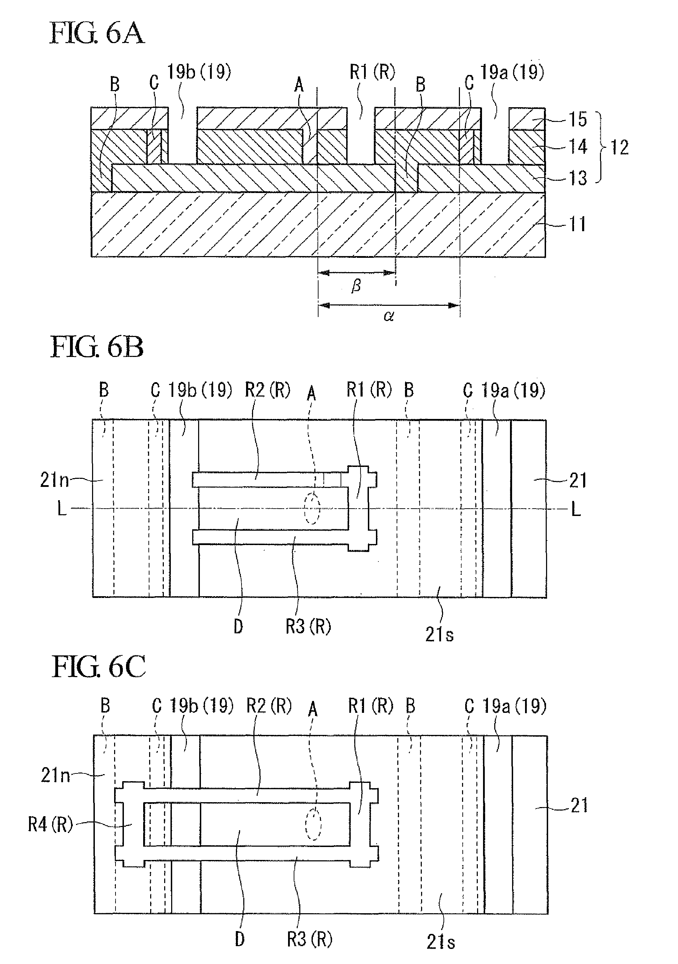

FIGS. 6A, 6B, and 6C are views schematically showing examples where repair lines R are formed by laser irradiation.

FIG. 6A is a cross-sectional view when three repair lines (R1 to R3) are formed, and FIG. 6B is a top view when three repair lines (R1 to R3) are formed.

Additionally, FIG. 6C is a top view when four repair lines (R1 to R4) are formed.

In addition, FIG. 6A is a cross-sectional view taken along the line L-L shown in FIG. 6B.

Firstly, as shown in FIGS. 6A, 6B, and 6C, in the photoelectric converter 12, one repair line R1 is formed by a laser, between the structural defect A and a connection portion C of the first electrode layer 13 and the second electrode layer 15, and at a region α including a portion B in which the semiconductor layer 14 is in contact with the substrate 11.

The repair line R1 is formed by removing the second electrode layer 15 and the semiconductor layer 14 by laser irradiation onto the second electrode layer 15.

In other cases, as a laser irradiation pattern as shown in FIGS. 6A, 6B, and 6C, one repair line R1 may be formed on a region β between the structural defect A and the portion B, the region β being included in the region α.

By forming the repair line R1 at the region β between the structural defect A and the portion B in the above-described manner, it is possible to further lower the region of the photoelectric converter to be removed or separated.

Next, as shown in FIG. 6B, two repair lines R2 and R3 are formed so as to insulate the structural defect A from the photoelectric converter 12.

Similarly to the repair line R1, the repair lines R2 and R3 can be formed by use of a laser.

That is, the structural defect A is surrounded by three repair lines R1, R2, and R3 and the scribing line 19b, and the region D in which the structural defect A exists is insulated from the photoelectric converter 12.

As described above, in the present application, one repair line R1 is formed in the region α, it is possible to reliably insulate the region D in which the structural defect A exists from the photoelectric converter 12 by surrounding the structural defect A by three repair line R1 to R3 including the repair line and one scribing line 19b.

Consequently, generation of malfunction which is caused by localized short-circuiting is suppressed, and it is possible to effectively suppress degradation of the photoelectric conversion characteristics, which is caused by the structural defect A.

Specifically, due to forming the repair line R1 in the region β, it is possible to narrow the region which is to be removed or separated from the photoelectric converter 12, and it is possible to repair the defect portion without significant degradation of the characteristics of a photovoltaic cell and without resulting in disfigurement.

The FIGS. 6A and 6B illustrate the state where the region D in which the structural defect A exists is separated using the repair lines R1 to R3 and a scribing line S1; however, as shown in FIG. 6C, the structural defect A can be surround by the repair lines R1 to R4 by forming a fourth repair line R4 on an adjacent compartment element 21n with a laser in a similar manner, and it is thereby possible insulate the structural defect A from the photoelectric converter 12.

Additionally, after forming repair lines R1 to R3 or R1 to R4, it is also possible to remove the region D by irradiating the region D in which the structural defect A exists with a laser.

Moreover, in the case where a plurality of structural defects A are proximal to each other, by surrounding the plurality of structural defect A by three of repair lines R1 to R3 and the scribing line 19b or by four repair lines R1 to R4, it is possible to collectively remove or separate from structural defects A.

The laser is not limited to a specific laser as long as the laser can remove the second electrode layer 15 and the semiconductor layer 14, and the removal can be performed, for example, using a green laser or the like.

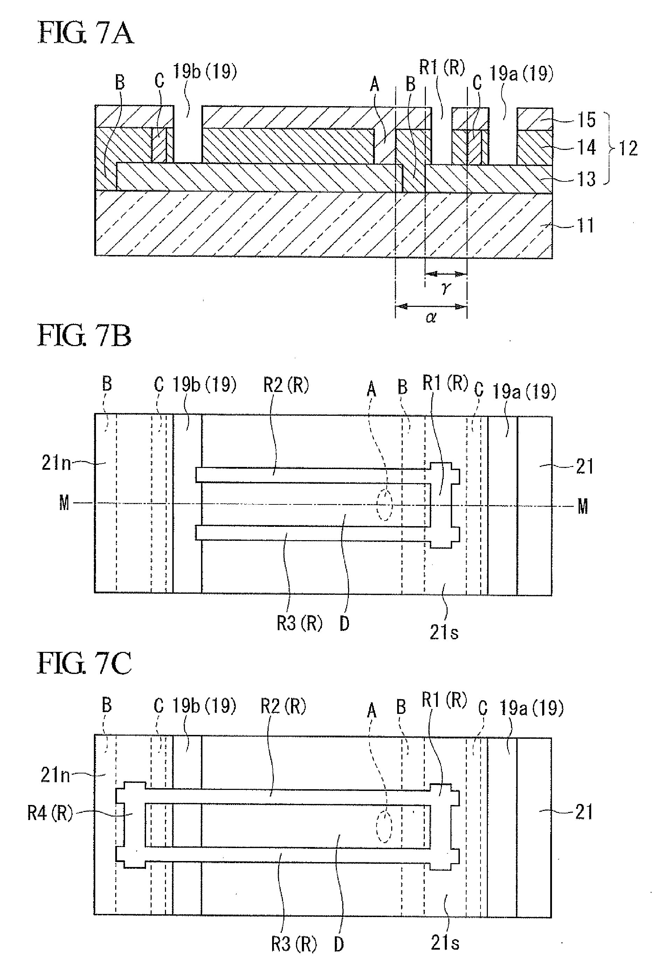

FIGS. 7A, 7B, and 7C are views schematically showing other examples where repair lines R are formed by laser irradiation.

FIG. 7A is a cross-sectional view when three repair lines (R1 to R3) are formed.

FIG. 7B is a top view when three repair lines (R1 to R3) are formed.

Additionally, FIG. 7C is a top view when four repair lines (R1 to R4) are formed.

In addition, FIG. 7A is a cross-sectional view taken along the line L-L shown in FIG. 7B.

Firstly, as shown in FIG. 7A, in the photoelectric converter 12, one repair line R1 is formed by a laser, between the structural defect A1 and a connection portion C of the first electrode layer 13 and the second electrode layer 15, and at a region α including a portion B in which the semiconductor layer 14 is in contact with the substrate 11.

The repair line R1 is formed by removing the second electrode layer 15 and the semiconductor layer 14 by laser irradiation onto the second electrode layer 15 as described above.

Next, as shown in FIG. 7B, two repair lines R2 and R3 are formed so as to insulate the structural defect A from the photoelectric converter 12 using a laser in a similar manner.

That is, the structural defect A is surrounded by three repair lines R1, R2, and R3 and the scribing line 19b, and the region D in which the structural defect A exists is insulated from the photoelectric converter 12.

As a laser irradiation pattern shown in FIGS. 7A, 7B, and 7C, one repair line R1 may be formed on a region γ between the portion B and the connection portion C, which is included in the region α.

Due to forming the repair line R1 on the region γ between the portion B and the connection portion C in the above-described manner, it is possible to narrow down the surface area of the photoelectric converter which is to be removed or separated so that the surface area is less than that of a conventional technique in which two scribing lines 119a and 119b are irradiated with a laser while crossing over as shown in FIG. 8.

Specifically, in the case where the structural defect A is adjacent to the portion B, there is a concern that a damage to portion B occurs at the time of laser irradiation; however, by forming the laser irradiation pattern as shown in FIGS. 7A, 7B, and 7C, it is possible to reliably remove or separate off the region D in which the structural defect A exists without occurring a damage to a photoelectric converter even when the structural defect A is adjacent to the portion B.

Consequently, generation of malfunction which is caused by localized short-circuiting is suppressed, and it is possible to effectively suppress degradation of the photoelectric conversion characteristics, which is caused by the structural defect A.

Additionally, as shown in FIG. 7C, in a similar manner to the above-described FIG. 6C, the structural defect A can be insulated from the photoelectric converter 12 by forming a fourth repair line R4 on an adjacent compartment element 21n so as to surround the structural defect A with the repair lines R1 to R4.

Furthermore, it is also possible to remove the region D in which the structural defect A exists by laser irradiation, and it is also possible to collectively remove or separate off a plurality of structural defects A.

A photovoltaic cell in which the structural defect A existing in the compartment element 21 is specified and removed or separated after the defect region specifying step (P3) and the defect repairing step (P4) in the above described manner is transmitted to a step (P5) for forming a protective layer, and a post-process is performed.

According to the foregoing photovoltaic cell manufacturing method of the present, it is possible to only remove a small-limited region including structural defect A in the defect repairing step, and it is possible to repair the defect portion without significant degradation of the characteristics of a photovoltaic cell and without resulting in disfigurement.

### Industrial Applicability

According to the present invention, it is possible to reduce the number of removal processes with a laser, which is lower than ever before, and suppress an adverse affect to a normal region of a photovoltaic cell.

For this reason, it is possible to manufacture a photovoltaic cell having a high level of photoelectric conversion efficiency without a structural defect.

## Claims

1. A photovoltaic cell manufacturing method, the photovoltaic cell including: a photoelectric converter in which at least a first electrode layer, a semiconductor layer, and a second electrode layer are stacked in layers in this order being formed on a face of a substrate; and a connection portion of the first electrode layer and the second electrode layer, the photoelectric converter having a plurality of compartment elements which are electrically separated by a predetermined size using scribing lines at which the semiconductor layer and the second electrode layer are removed, adjacent compartment elements being electrically connected to each other, the photovoltaic cell manufacturing method comprising:
a defect region specifying step in which a region at which the structural defect exists is specified in the photoelectric converter; and
a repairing step in which at least three repair lines in which the semiconductor layer and the second electrode layer are removed are formed by irradiating the photoelectric converter with a laser, the region at which the structural defect exists is surrounded by said at least three repair lines and one of the scribing lines, and the structural defect is removed or separated off, wherein
one of at least said three repair lines are formed at a region between the structural defect and the connection portion and at a region α including a contact portion of the semiconductor layer and the substrate in the photoelectric converter.

2. The photovoltaic cell manufacturing method according to claim 1, wherein
in the region α, one repair line is formed at a region β between the structural defect and the contact portion.

3. The photovoltaic cell manufacturing method according to claim 1, wherein
in the region α, one repair line is formed at a region γ between the contact portion and the connection portion.
